# EUROPÄISCHE PATENTANMELDUNG

(11) **EP 2 207 406 A2**
(43) Veröffentlichungstag der Anmeldung: **14.07.2010**
(21) Anmeldenummer: 09165629.8
(22) Anmeldetag: 16.07.2009
(51) Int. Cl.: H05K 1/11, H05K 1/18

(54) **Elektrische Schaltung, elektrisches Kleingerät, insbesondere ein Hörgerät, mit der elektrischen Schaltung und Verwendung der elektrischen Schaltung zur Herstellung des elektrischen Kleingeräts**

(30) Priorität: 27.08.2008 DE 102008044642
(71) Anmelder: Siemens Medical Instruments Pte. Ltd., Singapore 139959 (SG)
(72) Erfinder: Lim, Meng Kiang, Singapore 310060 (SG); Chan, Chor Fan, Singapore 730659 (SG); Lim, Hock Peng, Singapore 643660 (SG); Lim, Cher Huat, Singapore 570449 (SG); Yap, Chow Lan Stella, Singapore 574036 (SG); Chew, Leep Foong, Singapore 680541 (SG)
(74) Vertreter: Maier, Daniel Oliver

(57) **Zusammenfassung**

Die Erfindung betrifft eine elektrische Schaltung mit einer Leiterplatte (2), die seitlich in Form von zumindest einem länglichen Kontaktfortsatz (7-9) mit zumindest einer elektrischen Leiterbahn (10-12) und einem am Ende der Leiterbahn (10-12) angeordneten Lötstelle (13-15) verlängert ist. Der Kontaktfortsatz (7-9) erlaubt durch seine mechanische Biegsamkeit in aufwandsarmer Weise eine flexible Kontaktierung anderer elektronischer Bauteile. Solch eine elektrische Schaltung eignet sich besonders gut für elektrische Kleingeräte, insbesondere für ein Hörgerät (40).

## Beschreibung

Die Erfindung betrifft eine elektrische Schaltung, die insbesondere für elektrische Kleingeräts, z.B. in Form eines Hörgeräts, geeignet ist.

Elektrische Geräte weisen meistens eine Vielzahl von elektrischen Schaltungen auf, die miteinander elektrisch verbunden sind. Es sind verschieden Arten von elektrischen Verbindungen bekannt. Eine elektrische Schaltung kann z.B. direkt über elektrisch leitende Stifte auf eine andere elektrische Schaltung verlötet sein.

Es ist auch bekannt, elektrische Schaltungen über flexible Leitungsdrähte miteinander zu verbinden, wobei die Leitungsdrähte jeweils an ihren beiden Enden mit den beiden elektrischen Schaltungen verlötet werden. Die flexiblen Leitungsdrähte erlauben eine variable Beabstandung der elektrischen Schaltungen und eine variable Ausrichtung der elektrischen Schaltungen zueinander. Die Leitungsdrähte stellen aber einen zusätzlichen Materialaufwand dar und erfordern mit dem beidseitigen Verlöten einen zusätzlichen Arbeitsaufwand.

Aus der Druckschrift DE 691 11 668 T2 ist ein Hörgerät mit einer elektrischen Schaltung bekannt, deren elektrische Komponenten jeweils als Module zusammengefügt werden. Zur Verbindung der Module, die auf Schaltungsplatten angeordnet sein können, sind Leiterbahnen auf weiteren, flexiblen Schaltungsplatten vorgesehen. Die Leiterbahnen auf den weiteren, flexiblen Schaltungsplatten verbinden die jeweiligen Module über jeweilige Lötverbindungen.

Aus der Druckschrift DE 10 2005 006 856 B3 ist ebenfalls ein Hörgerät bekannt. Es weist eine elektrische Schaltung auf einer Leiterplatte auf, mit der ein bewegliches Bedienelement verbunden ist. Das Bedienelement ist mit der Leiterplatte durch Leiterbahnen auf einer weiteren, flexiblen Leiterplatte verbunden,

Der Erfindung liegt somit die Aufgabe zugrunde, eine aufwandsarme aber dennoch flexible elektrische Kontaktierung einer elektrischen Schaltung zu ermöglichen.

Die Aufgabe wird gelöst durch die elektrische Schaltung gemäß Anspruch 1, durch ein elektrisches Kleingerät mit der elektrischen Schaltung gemäß Anspruch 12 und durch eine Verwendung der elektrischen Schaltung gemäß Anspruch 14. Vorteilhafte Ausgestaltungen sind Gegenstand der jeweils rückbezogenen Ansprüche.

Durch eine seitliche Verlängerung einer bei den meisten elektrischen Schaltung ohnehin vorgesehnen Leiterplatte in Form von zumindest einem flexiblen Kontaktfortsatz mit einer Leiterbahn und einer Lötstelle wird eine ähnlich flexible elektrische Kontaktierung ermöglicht wie mithilfe eines auf die Leiterplatte gelöteten elektrischen Leitungsdrahts, wobei durch die Fortbildung ohnehin vorhandener Teile der Material- und Fertigungsaufwand reduziert wird. Darüber hinaus wird der Aufwand für das Verlöten halbiert, da der Kontaktfortsatz konstruktionsbedingt bereits an einer Seite der elektrischen Schaltung elektrisch verbunden ist.

Um eine mit einem elektrischen Leitungsdraht vergleichbare Flexibilität zu ermöglichen, die über ein bloßes Verwinkeln hinausgeht, muss der Kontaktfortsatz länger sein als breit. Der Kontaktfortsatz kann z.B. doppelt, fünfmal oder zehnmal so lang sein wie breit. Mit zunehmender Länge im Verhältnis zur Breite steigt die mechanische Biegsamkeit.

Die Flexibilität der elektrischen Verbindungsmöglichkeit hat den besonderen Vorteil, dass dieselbe elektrische Schaltung ohne weitere Anpassung in verschiedenen Geräten verwendet werden kann. Auf diese Weise ermöglicht die Erfindung z.B. in einfacher Weise die Herstellung von in Ihrer Form verschiedenen Hörgeräten mit den gleichen oder ähnlichen Funktionen

Die elektrische Schaltung ist besondern gut geeignet zur Herstellung eines elektrischen Kleingeräts, insbesondere in Form eines Hörgeräts, eines Mobiltelefons oder eines funkbasierten Headsets zur Aufnahme und Wiedergabe von Sprache. Bei kleinen Geräten ist die Reduktion der Anzahl der Lötvorgänge ein besonders wesentlicher Vorteil.

Eine Lötstelle, die über einen Anteil des Kontaktfortsatzes verlängert ist, ermöglicht eine Weiterverwendung der Lötstelle bei einem Verkürzen des Kontaktfortsatzes, so dass die elektrische Schaltung besonders einfach an unterschiedliche Verwendungsformen angepasst werden kann. So ist es z.B. möglich, dieselbe elektrische Schaltung einerseits in einem Gerät zu verwenden, in dem die Kontaktfortsätze eine Verbindung über eine große Distanz überbrücken muss, und andererseits in einem Gerät, das aufgrund der kompakten Bauform einen kurzen Kontaktfortsatz erfordert.

Oft ist eine mehrfache elektrische Verbindung zwischen Bauteilen eines Geräts erforderlich. In diesem Fall erlauben mehrere getrennte Kontaktfortsätze eine höhere mechanische Biegsamkeit als ein breiter Kontaktfortsatz mit mehreren Leiterbahnen. Dies ist besonders dann vorteilhaft, wenn von der elektrischen Schaltung eine elektrische Verbindung zu einem anderen elektrischen Bauteil hergestellt werden soll, das sich im bestimmungsgemäßen Betrieb des Geräts relativ zu der Schaltung bewegt.

Eine besonders kompakte Bauform wir durch einen Kontaktfortsatz mit einer Vielzahl von Leiterbahnen ermöglicht. Um einerseits ausreichend groß dimensioniert Lötstellen für die Leiterbahnen vorsehen zu können und andererseits dennoch einen schmalen Endbereich des Kontaktfortsatzes zu ermöglichen, sind die Lötstellen zum elektrischen Kontaktieren der Leiterbahnen in Längsrichtung des Kontaktfortsatzes aufgereiht.

In der folgenden detaillierten Figurenbeschreibung werden nicht einschränkend zu verstehende Ausführungsbeispiele mit deren Merkmalen und weiteren Vorteilen anhand der schematischen Zeichnungen besprochen. In dieser zeigen jeweils in einer perspektivischen Darstellung:
- Fig. 1: einen Hybridschaltkreis mit drei Kontaktfortsätzen;
- Fig. 2: in einer vergrößerten Darstellung einen Kontaktfortsatz mit einer elektrischen Leiterbahn und einer am Ende der Leiterbahn angeordneten Lötstelle zum oberflächlichen Verlöten eines elektrischen Kontakts;
- Fig. 3: einen Kontaktfortsatz mit drei Leiterbahnen und einem Mikrofon, das oberflächlich auf die drei Lötstellen der Leiterbahnen aufgelötet ist;
- Fig. 4: der Kontaktfortsatz mit dem Mikrofon gemäß Fig. 3 aus einer anderen Perspektive;
- Fig. 5: analog zu Fig. 2 in einer vergrößerten Darstellung einen weiteren Kontaktfortsatz mit einer Lötstelle mit einem durchplattierten Loch;
- Fig. 6: analog zu Fig. 3 einen Kontaktfortsatz mit einem Mikrofon, das auf drei Lötstellen mit durchplattierten Löchern aufgelötet ist;
- Fig. 7: der Kontaktfortsatz mit dem Mikrofon gemäß Fig. 6 aus einer Perspektive von unten;
- Fig. 8: der Kontaktfortsatz mit dem Mikrofon gemäß Fig. 6 und 7 aus einer weiteren Perspektive;
- Fig. 9: ein Hörgerät.

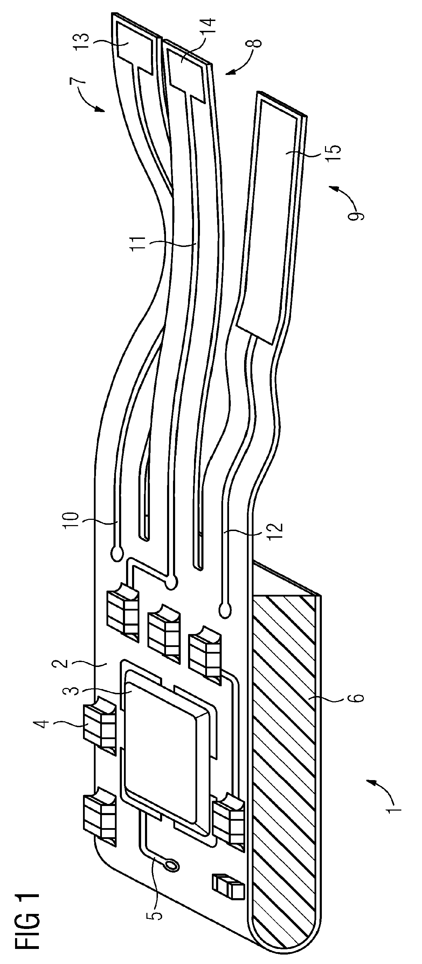

**Figur 1** zeigt einen Hybridschaltkreis 1 mit einer Leiterplatte 2, auf der ein integrierter Schaltkreis 3, einige SMD-Bauteile 4 (SMD, engl.: "Surface Mounted Device") und einige Leiterbahnen 5 angeordnet sind. Die Leiterplatte 2 ist an einer Stelle um 180° gebogen und schließt von zwei Seiten einen mit Kunststoff 6 ausgegossenen Bereich ein, in dem weitere elektrische Bauteile angeordnet sind, die ebenfalls die Funktion des Hybridschaltkreises 2 mitbestimmen.

Der obere Teil der Leiterplatte 2 ist seitlich in Form von drei flexiblen Kontaktfortsätzen 7-9 verlängert, die jeweils eine elektrische Leiterbahn 10-12 und an dessen Ende eine Lötstelle 13-15 aufweisen. An die Lötstellen 13-15 können elektrische Kontakte verlötet werden. Die Kontaktfortsätze 7-9 sind jeweils in Ihrer mechanischen Biegsamkeit vergleichbar zu einem herkömmlichen Leitungsdraht. In diesem Ausführungsbeispiel sind die Kontaktfortsätze 7-9 jeweils besonders biegsam, da das Verhältnis ihrer Länge zu ihrer Breite etwa zehn beträgt.

Der untere Teil der Leiterplatte 2 kann wie der obere Teil ebenfalls in Form von zumindest einem Kontaktfortsatz verlängert sein.

Die Ausführung als drei getrennte Kontaktfortsätze 10-12 ist besonders flexibel verbindbar. Im Gegensatz zu einem einzigen breiten Kontaktfortsatz mit drei Leitungsbahnen 10-12 ist diese Ausgestaltung besonders biegsam. Außerdem können sowohl die Abstände und die Anordnung der Lötstellen 13-15 relativ zueinander flexibel variiert werden.

Die Lötstellen 13 und 14 der oberen beiden Kontaktfortsätzen 7 bzw. 8 sind in gewöhnlicher Weise annähernd quadratisch ausgebildet. Die Lötstelle 15 des unteren Kontaktfortsatzes 9 hingegen ist über einen Anteil der Länge des Kontaktfortsatzes 9 verlängert. In diesem Fall erstreckt sich dieser Anteil etwa über die Hälfte des Kontaktfortsatzes 9. Durch diese längliche Ausbildung der Lötstelle 15 kann der Kontaktfortsatz 9 fast auf die Hälfte gekürzt werden, da auch bei einer solchen Kürzung ein ausreichender Teil der Lötstelle 15 übrig bleibt.

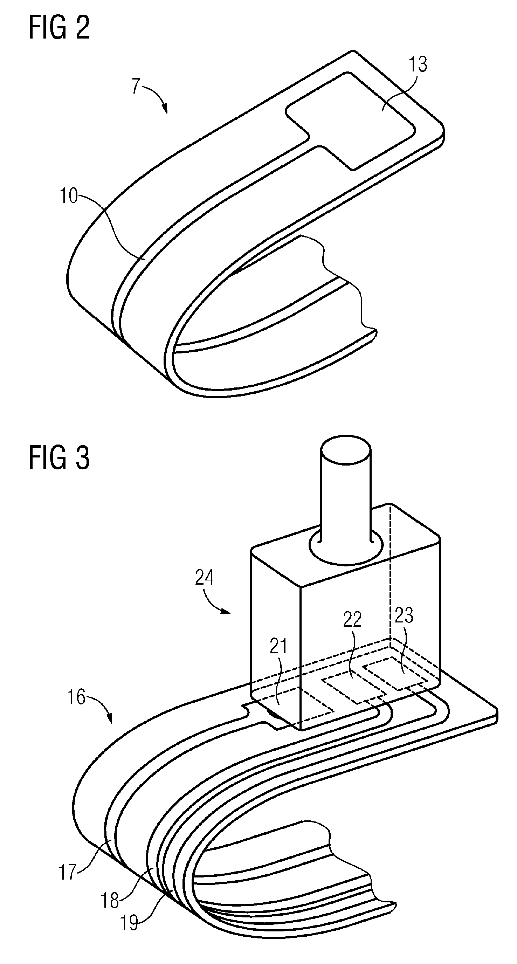

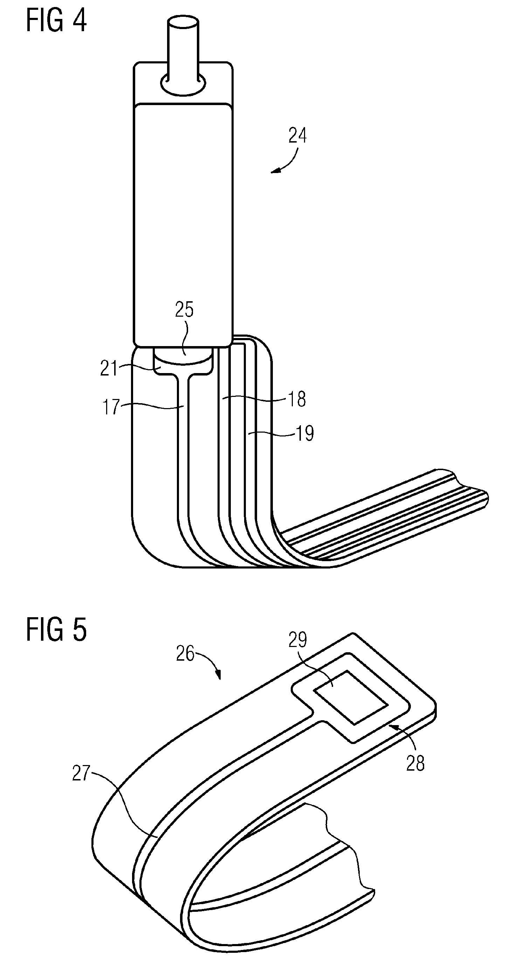

Die Kontaktfortsätze 7-9 sind sowohl für oberflächliche Verlötung (engl.: "suface plated") als auch für Durchkontaktierung (engl.: engl.: "plated through hole") geeignet. Die Figuren 2-4 zeigen Ausführungsbeispiele der Kontaktfortsätze mit Lötstellen zur oberflächlichen Verlötung von elektrischen Kontakten wohingegen die Figuren 5-8 Ausführungsbeispiele mit Lötstellen zur Durchkontaktierung darstellen.

**Figur 2** zeigt in einer Vergrößerungsdarstellung den oberen Kontaktfortsatz 13 aus Figur 1 mit der elektrischen Leiterbahn 10 und dem am Ende der Leiterbahn 10 angeordneten Lötstelle 13 zum oberflächlichen Verlöten eines elektrischen Kontakts.

Die **Figuren 3** **und** **4** zeigen aus zwei unterschiedlichen Perspektiven einen Kontaktfortsatz 16, der drei Leiterbahnen 17-19 aufweist und dadurch im Vergleich zu drei einzelnen Kontaktfortsätzen 7-9 aus Figur 1 kompakt ist. Die Leiterbahnen 17-19 enden an drei Lötstellen 21-23, auf denen ein Mikrofon 24 mit oberflächlich auf den Lötstellen 21-23 aufgetragenem Lötzinn 25 verlötet ist.

Durch die Anordnung der Lötstellen 21-23 am Ende der Leiternbahnen 17-19 in Längsrichtung des Kontaktfortsatzes 16 wird eine besonders kompakte Bauweise ermöglicht. Wären die Lötstellen 21-23 hingegen diagonal zur Längsrichtung des Kontaktfortsatzes 16, dann hätte dieser an seinem Ende etwas doppelt so breit ausgeführt werden müssen.

Diese Ausführungsform mit dem Mikrofon 24, dem kompakten Kontaktfortsatz 16 und den längs aufgereihten Lötstellen 21-23 ist besonders für Hörgeräte geeignet, die elektrische Bauteile auf kleinem Raum vereinen.

**Figur 5** zeigt in einer Vergrößerungsdarstellung einen Kontaktfortsatz 26, der im Gegensatz zu dem Kontaktfortsatz 7 aus Figur 2 eine Lötstelle 28 mit einem durchplattierten Loch 29 aufweist. Die Lötstelle 28 ist über eine Leiterbahn 27 mit einer elektrischen Schaltung 1 elektrisch verbunden.

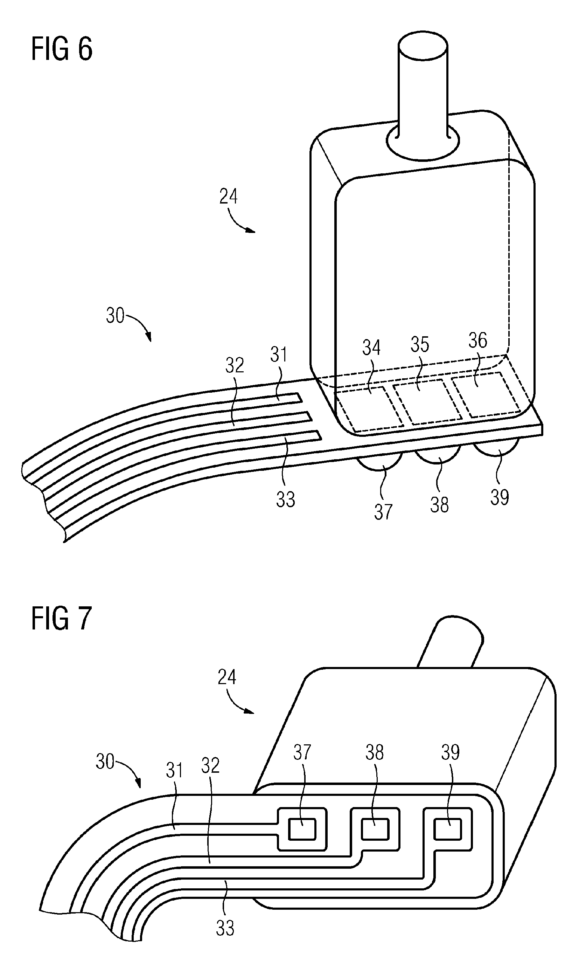

Die **Figuren 6-8** zeigen jeweils aus einer anderen Darstellungsperspektive einen Kontaktfortsatz mit drei Leiterbahnen 31-33, an deren Ende jeweils eine Lötstelle 34-36 vorhanden ist. Die Lötstellen 34-36 weisen jeweils ein durchplattiertes Loch auf, das zur Befestigung eines Mikrofons 24 jeweils mit Lötzinn 34-36 ausgefüllt ist.

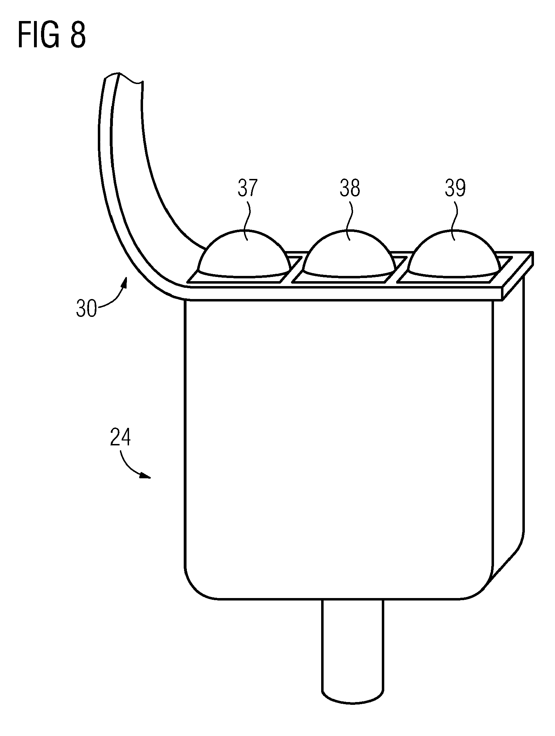

Figur 6 entspricht einer Perspektive seitlich von oben, Figur 7 im Wesentlichen von unten und Figur 8 im Wesentlichen von der Seite.

**Figur 9** zeigt ein Hörgerät 40, das sich aufgrund seines geringen Gehäusevolumens besonders gut für die Verwendung einer elektrischen Schaltung gemäß einer der zuvor beschriebenen Ausführungsformen eignet.

Die flexiblen Kontaktfortsätze 7-9, 16, 26 können zusätzlich mit einer Abschirmung gegen elektromagnetische Interferenzen versehen sein. Diese Abschirmung reduziert elektromagnetische Störungen des Stromflusses in den Kotaktfortsätzen 7-9, 16, 26. Diese Störungen können sich in einem Hörgerät 40 z.B. durch eine Rauschen oder andere Störgeräusche äußern. Dies also auch die Tatsache, dass aufgrund der kompakten Bauform von Hörgeräten 40 elektromagnetische Interferenzen oft vorkommen können, zeichnet den besonderen Vorteil dieser Ausgestaltung in Bezug auf Hörgeräte 40 aus. Die elektromagnetische Abschirmung wird beispielsweise durch eine Silberpaste oder durch eine Laminierung der flexiblen Kontaktfortsätze 7-9, 16, 26 mit einer Silberfolie realisiert.

Zumindest eine Ausführungsform der Erfindung betrifft zusammengefasst eine elektrische Schaltung mit einer Leiterplatte, die seitlich in Form von zumindest einem länglichen Kontaktfortsatz mit zumindest einer elektrischen Leiterbahn und einem am Ende der Leiterbahn angeordneten Lötstelle verlängert ist. Der Kontaktfortsatz erlaubt durch seine mechanische Biegsamkeit in aufwandsarmer Weise eine flexible Kontaktierung anderer elektronischer Bauteile. Solch eine elektrische Schaltung eignet sich besonders gut für elektrische Kleingeräte, insbesondere für ein Hörgerät.

## Patentansprüche

1. Elektrische Schaltung mit einer Leiterplatte (2), die seitlich in Form von zumindest einem flexiblen Kontaktfortsatz (7-9, 16, 26) mit zumindest einer elektrischen Leiterbahn (10-12, 17-19, 27, 31-33) und einem am Ende der Leiterbahn (10-12, 17-19, 27, 31-33) angeordneten Lötstelle (13-15, 21-23, 28, 34-36) verlängert ist, wobei der Kontaktfortsatz (7-9, 16, 26) länger ist als breit.

2. Elektrische Schaltung nach Anspruch 1, wobei die Lötstelle (15) über einen Anteil der Länge des Kontaktfortsatzes (9) so verlängert ist, dass ihre Länge längs des Kontaktfortsatzes (9) mindestens doppelt so groß wie ihre Breite quer zum Kontaktfortsatz (9) ist.

3. Elektrische Schaltung nach Anspruch 1 oder 2, wobei die Lötstelle (15) mindestens über die Hälfte der Längserstreckung des des Kontaktfortsatzes (9) verlängert ist.

4. Elektrische Schaltung nach einem der Ansprüche 1-3 mit einer Vielzahl von flexiblen Kontaktfortsätzen (7-9).

5. Elektrische Schaltung nach einem der Ansprüche 1-4, wobei der Kontaktfortsatz (16, 30) eine Vielzahl von Leiterbahnen (17-19, 31-33) aufweist, an deren Ende jeweils eine Lötstelle (21-23, 34-36) angeordnet ist.

6. Elektrische Schaltung nach Anspruch 5, wobei die Lötstellen (21-23, 34-36) am Ende der Leiterbahn in Längsrichtung des Kontaktfortsatzes (16, 30) aufgereiht sind.

7. Elektrische Schaltung nach einem der Ansprüche 1-6, wobei die elektrische Schaltung als Hybridschaltkreises (1) ausgebildet ist.

8. Elektrische Schaltung nach Anspruch 7, wobei der Hybridschaltkreis (1) Funktionen eines Hörgeräts (40) unterstützt.

9. Elektrische Schaltung nach Anspruch 8, wobei der Hybridschaltkreis den Betrieb eines Mikrofons (24) unterstützt, das über den Kontaktfortsatz (16, 30) elektrisch kontaktiert wird.

10. Elektrische Schaltung nach einem der Ansprüche 1-9, wobei der zumindest eine elektrische Kontaktfortsatz (7-9, 16, 26) mit einer Abschirmung gegen elektromagnetische Interferenzen versehen ist.

11. Elektrische Schaltung nach Anspruch 10, wobei die Abschirmung in Form einer auf die flexiblen Kontaktfortsätze (7-9, 16, 26) aufgetragene Silberpaste und/oder durch eine Laminierung der flexiblen Kontaktfortsätze (7-9, 16, 26) mit einer Silberfolie ausgebildet ist.

12. Elektrisches Kleingerät mit einer elektrischen Schaltung nach einem der Ansprüche 1-11.

13. Elektrisches Kleingerät nach Anspruch 12, wobei das elektrische Kleingerät in Form eines Hörgeräts (40) ausgebildet ist.

14. Verwendung der elektrischen Schaltung nach einem der Ansprüche 1-11 zur Herstellung eines elektrischen Kleingeräts.

15. Verwendung nach Anspruch 14 zur Herstellung eines elektrischen Kleingeräts in Form eines Hörgeräts (40).
